# EUROPEAN PATENT APPLICATION

(11) **EP 4 550 424 A1**
(43) Date of publication of application: **07.05.2025**
(21) Application number: 24156668.6
(22) Date of filing: 08.02.2024
(51) Int. Cl.: H01L 31/0224, H01L 31/05

(54) **SOLAR CELL**

(30) Priority: 06.11.2023 CN 202311469848
(71) Applicant: Jinko Solar (Haining) Co., Ltd., Haining City, Zhejiang 314415 (CN)
(72) Inventor: LI, Huimin, Zhejiang (CN); XU, Menglei, Zhejiang (CN); YANG, Jie, Zhejiang (CN); CHEN, Xiao, Zhejiang (CN); ZHANG, Xinyu, Zhejiang (CN)
(74) Representative: Balder IP Law, S.L.

(57) **Abstract**

A solar cell is provided, including: a substrate; a passivation layer formed over a surface of the substrate; fingers arranged in a first direction and extending in a second direction, where the fingers penetrate the passivation layer to be electrically connected to the substrate and include first fingers and second fingers which are alternatingly arranged; connection electrodes, where each of the connection electrodes is in electrical contact with end portions of at least two adjacent first fingers on a same side and includes one of the following: at least a first connection section and a second connection section connected to each other, where the first connection section is connected to an end portion of a respective finger of the at least two adjacent first fingers, the first connection section and the respective finger has an included angle that is not equal to 180°, and the first connection section and the second connection section has an included angle that is not equal to 180°; and a curved wave-like structure.

## Description

### TECHNICAL FIELD

Embodiments of the present disclosure relate in general to the field of photovoltaics, and in particular to a solar cell and a photovoltaic module.

### BACKGROUND

Currently, with gradual depletion of fossil energy sources, solar cells are being used more and more widely as a new energy alternative, which convert light energy from the sun into electrical energy. The solar cells utilize the photovoltaic principle to generate carriers, and then use electrodes to draw the carriers out, thereby facilitating efficient utilization of the electrical energy.

Conventional solar cells mainly include interdigitated back contact (IBC) cells, tunnel oxide passivated contact (TOPCON) cells, passivated emitter and real cells (PERC), heterojunction cells, etc. The photovoltaic conversion efficiency of solar cells is improved by reducing optical losses and photogenerated carrier recombination on the surface and in the body of a silicon substrate through different film layer settings and functional limitations.

In the conventional solar cells, the current generated by the cell is collected and output by finger electrodes and busbars, and the current generated by the cell is transmitted to a module end by pads set on the busbars. However, the solar cells in the existing technology have weak capabilities to collect current, which affects improvement of the photoelectric conversion efficiency of the solar cells.

### SUMMARY

Some embodiments of the present disclosure provide a solar cell and a photovoltaic module, which are at least conducive to improving weak current collection capabilities of edge grid lines in the solar cell.

Some embodiments of the present disclosure provide a solar cell, including: a substrate; a passivation layer formed over a surface of the substrate; fingers including rows of first fingers and rows of second fingers alternatingly arranged along a first direction, each finger of the fingers extending in a second direction, each row of first fingers including a corresponding set of first fingers arranged at intervals in the second direction and each row of second fingers including a corresponding set of second fingers arranged at intervals in the second direction, where each row of first fingers is between two adjacent rows of second fingers, and where the fingers penetrate the passivation layer to be electrically connected to the substrate; connection electrodes, where each of the connection electrodes is in electrical contact with end portions of at least two adjacent first fingers on one side of the rows of first fingers and includes one of a sectional structure and a curved wave-like structure; where the sectional structure includes at least a first connection section and a second connection section connected to each other, and where the first connection section is connected to an end portion of a respective finger of the at least two adjacent first fingers, the first connection section and the respective finger has an included angle that is not equal to 180°, and the first connection section and the second connection section has an included angle that is not equal to 180°.

In some embodiments, the substrate has a first boundary, a second boundary, a third boundary, and a fourth boundary adjacent to each other, where the first boundary is opposite to the third boundary in the first direction, and the second boundary is opposite to the fourth boundary in the second direction; where the solar cell further includes edge busbars adjacent to the second boundary; and where the edge busbars are in electrical contact with the second fingers arranged in the first direction.

In some embodiments, solar cell further includes solder joints provided on the passivation layer, where each of the solder joints is electrically connected to a respective one of the edge busbars, and where each of the solder joints and the second boundary have a first distance that is greater than a second distance between any of the edge busbars and the second boundary.

In some embodiments, each of the connection electrodes and the second boundary have a third distance greater than the second distance.

In some embodiments, each of the edge busbars includes a first connection line extending in the first direction, at least one electrical connection line, and a connection pattern; where the at least one electrical connection line is provided between the first connection line and the connection pattern and extends in a direction intersecting with the first direction, the connection pattern is provided on and in electrical contact with some of the second fingers, and the first connection line is provided on a side of the at least one electrical connection line close to the second boundary; and where a respective one of the solder joints is provided on the connection pattern.

In some embodiments, the connection pattern has a hollow region, and the respective one of the solder joints partially overlaps with the hollow region.

In some embodiments, each of the connection electrodes includes a plurality of groups of first connection sections and second connection sections which are alternatingly arranged.

In some embodiments, the connection electrodes have materials the same as materials of the fingers.

In some embodiments, the curved wave-like structure includes a plurality of arcs each having a radian in a range of 0.1 rad to π.

In some embodiments, each of the connection electrodes has a width less than 30 µm.

Some embodiments of the present disclosure further provide a photovoltaic module including: at least one cell string each formed by connecting a plurality of solar cells according to any one of the above embodiments; at least one solder strip each configured to electrically connect the plurality of solar cells to form each of the at least one cell string; at least one encapsulating adhesive film each configured to cover a surface of a respective cell string; and at least one cover plate each configured to cover a surface of a respective encapsulating adhesive film facing away from the plurality of cell strings.

In some embodiments, the at least one solder strip each is soldered to solder joints of each of the plurality of solar cells, and each of the at least one solder strip has an orthographic projection on the substrate that does not overlap with an orthographic projection of a respective one of the edge busbars on the substrate.

### BRIEF DESCRIPTION OF THE DRAWINGS

One or more embodiments are exemplarily described with figures in the accompanying drawings corresponding thereto, which are not intended to limit these embodiments. Unless otherwise stated, the figures in the accompanying drawings do not constitute scale limitations. In order to more clearly illustrate the technical solutions in the embodiments of the present disclosure or conventional technologies, the accompanying drawings that need to be used in the embodiments are briefly described below, and it is apparent that the drawings in the following description are merely some embodiments of the present disclosure. For a person of ordinary skill in the art, other drawings may also be obtained according to these drawings.
FIG. 1 is a schematic structural diagram of a first solar cell according to an embodiment of the present disclosure.
FIG. 2 is a cross-sectional view of FIG. 1 along section line A1-A2.
FIG. 3 is a schematic structural diagram of a second solar cell according to an embodiment of the present disclosure.
FIG. 4 is a schematic structural diagram of a connection electrode in the second solar cell according to an embodiment of the present disclosure.
FIG. 5 is a schematic structural diagram of a third solar cell according to an embodiment of the present disclosure.
FIG. 6 is a partial enlarged view of part B in FIG. 5.
FIG. 7 is a schematic structural diagram of a connection electrode in the third solar cell according to an embodiment of the present disclosure.
FIG. 8 is a schematic structural diagram of a fourth solar cell according to an embodiment of the present disclosure.
FIG. 9 is a partial enlarged view of part C in FIG. 8.
FIG. 10 is a schematic structural diagram of a photovoltaic module according to an embodiment of the present disclosure.
FIG. 11 is a cross-sectional view of FIG. 10 along section line M1-M2.
FIG. 12 is a partial schematic structural diagram of a cell and a solder strip in a photovoltaic module according to an embodiment of the present disclosure.

### DETAILED DESCRIPTION OF THE EMBODIMENTS

It can be seen from the Background that current collection capabilities of edge electrodes in the conventional solar cells are weak.

It is found that one of the reasons for the weak current collection capabilities of the edge electrodes of the conventional solar cell is that due to the particularity of the IBC cell in the conventional solar cells, i.e., a rear surface of the cell has electrodes (fingers) with the first polarity and electrodes (fingers) with the second polarity, a gap needs to be set on the electrode with one of the first and second polarities for a solder strip or a busbar connected to the electrode with the other of the first and second polarities to pass, so that portions of the fingers close to the edges of the cell may not able to collect the current.

In the embodiments of the present disclosure, the connection electrodes are provided, each connection electrode is in electrical contact with end portions of at least two adjacent first fingers on a same side, and a hollow square-shaped electrode is formed by the connection electrode and the fingers, so that an area of a portion of the electrode at the edge is increased, and the current collection capability is improved.

In addition, the connection electrode has a curved wave-like shape. In the conventional process of preparing the connection electrode, the scraper needs to push the paste to fill holes of the screen plate in a direction parallel to an arrangement direction of the fingers and perpendicular to an extending direction of the fingers as well as the substrate, so as to make the paste cover a surface of the passivation layer. Since a total area of holes on the same horizontal line is small, the paste can quickly fill the holes, so that the holes on different horizontal lines are communicate, thus the continuity of the connection electrode is good so as to avoid the gap, and the connection electrode can fully play the function of collecting the current. The connection electrode has a curved wave-like shape, compared with a straight linear shape, an contact area between an end portion of the connection electrode and an end portion of the first finger connected with the connection electrode is large, so that the problem of the gap between the connection electrode and the first finger is avoided, and the contact area between the connection electrode and the first finger is large, thus the contact resistance between the connection electrode and the first finger is small, which improves the photoelectric conversion efficiency of the solar cell.

The connection electrode includes at least a first connection section and a second connection section that are connected to each other, an included angle between the first connection section and the finger is not equal to 180°, and an included angle between the first connection section and the second connection section is not equal to 180°. In the process of preparing the connection electrode including the first connection section and the second connection section, for the connection electrodes on the same horizontal line, less paste needs to be filled, thus the paste can be continuous on the surface of the passivation layer, and the gap does not appear between the first finger and the first connection section.

Embodiments of the present disclosure will be described in detail below with reference to the accompanying drawings. Those of ordinary skill in the art may understand that in the embodiments of the present disclosure, many technical details are set forth in order to make the reader better understand the present disclosure. However, the technical solutions set forth in the present disclosure may be implemented even without these technical details and various changes and modifications based on the following embodiments.

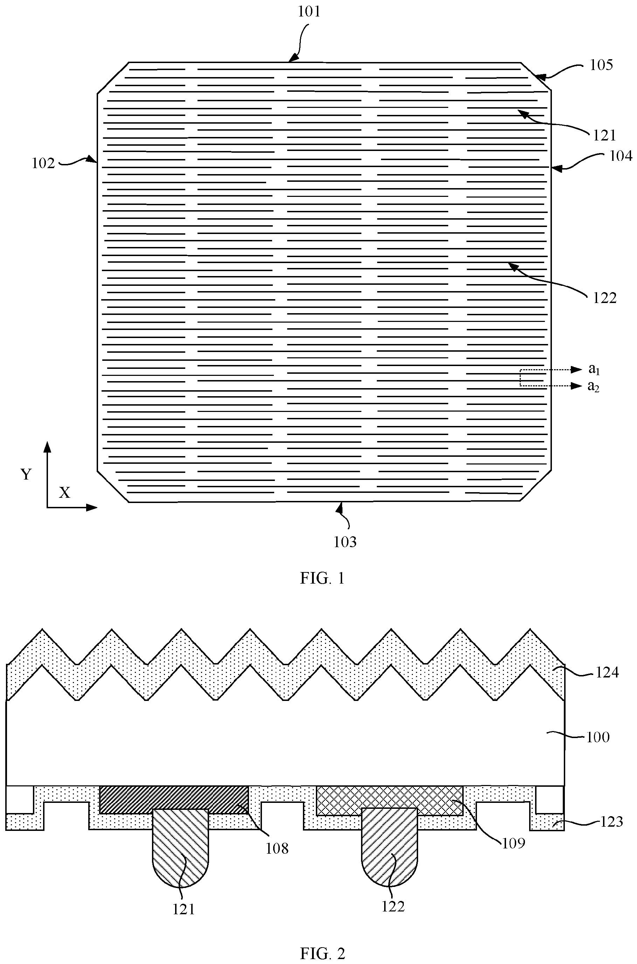

FIG. 1 is a schematic structural diagram of a first solar cell according to an embodiment of the present disclosure, and FIG. 2 is a cross-sectional schematic diagram of FIG. 1 along section line A1-A2.

Referring to FIG. 1 and FIG. 2, the solar cell includes a substrate 100, a passivation layer 123 formed over a surface of the substrate 100, and fingers including rows of first fingers 121 and rows of second fingers 122 alternatingly arranged along a first direction Y, each finger of the fingers extending in a second direction X, each row of first fingers 121 including a corresponding set of first fingers 121 arranged at intervals in the second direction and each row of second fingers 122 including a corresponding set of second fingers 122 arranged at intervals in the second direction X. Each row of first fingers 121 is between two adjacent rows of second fingers 122. The fingers penetrate the passivation layer 123 to be electrically connected to the substrate 100.

In some embodiments, the solar cell may be an IBC cell, that is, including first fingers 121 having first polarities and second fingers 122 having second polarities on the same side of the substrate 100.

In some embodiments, a material of the substrate 100 includes an element semiconductor material. Specifically, the element semiconductor material is composed of a single element, for example, silicon or germanium. The elemental semiconductor material may be in a monocrystalline state, a polycrystalline state, an amorphous state, or a microcrystalline state (having the single crystal state and the amorphous state at the same time), for example, silicon may be at least one of monocrystalline silicon, polycrystalline silicon, amorphous silicon, or microcrystalline silicon.

In some embodiments, the material of the substrate 100 includes a compound semiconductor material. Common compound semiconductor materials include, but are not limited to, silicon germanium, silicon carbide, gallium arsenide, indium gallium, perovskite, cadmium telluride, copper indium selenium, etc. The substrate 100 may also include a sapphire substrate, a silicon substrate on an insulator, or a germanium substrate on the insulator.

In some embodiments, the substrate 100 includes an N-type semiconductor substrate or a P-type semiconductor substrate. The N-type semiconductor substrate is doped with an N-type doping element, and the N-type doping element may be any one of group V elements such as phosphorus (P), bismuth (Bi), antimony (Sb), arsenic (As), etc. The P-type semiconductor substrate is doped with a P-type doping element, and the P-type doping element may be any one of group III elements such as boron (B), aluminum (Al), gallium (Ga), indium (In), etc.

In some embodiments, the substrate 100 includes a first surface and a second surface opposite to each other. In some embodiments, the first surface of the substrate 100 is a front surface and the second surface is a rear surface. In some embodiments, the first surface of the substrate 100 is a rear surface and the second surface is a front surface. That is, the solar cell is a single-sided cell, and the front surface may be used as a light receiving surface for receiving incident light and the rear surface may be used as a backlight surface. In some embodiments, the solar cell is a double-sided cell, that is, both the first surface and the second surface of the substrate 100 may be used as light receiving surfaces for receiving incident light. In some embodiments of the present disclosure, as an example, the fingers are formed on the second surface of the substrate, and the second surface of the substrate is the rear surface.

In some embodiments, the first surface of the substrate 100 has a textured structure, and the textured structure includes a regular-shaped pyramid textured structure and an irregular-shaped black silicon. An inclined surface of the textured structure can increase internal reflection of incident light, thereby improving the absorption and utilization rate of the substrate on incident light, and further improving the cell efficiency of the solar cell.

In some embodiments, the first surface of the substrate 100 has a front surface field (FSF) in which doped ions have a conductivity type the same as a conductivity type of doped ions in the substrate, and surface minority concentration is reduced by using the field passivation effect, so that a surface recombination rate is reduced, meanwhile, a series resistance is reduced, and electron transmission capability is improved.

In some embodiments, the first surface of the substrate 100 is the front surface and the second surface is the rear surface, and the second surface of the substrate 100 is a polishing surface, and the polishing surface refers to a flat surface formed by polishing solution or laser etching to remove the textured structure of the surface. After polishing, flatness of the second surface is increased, reflection of long-wave light is increased, and secondary absorption of projection light is promoted, thereby improving a short-circuit current. Meanwhile, due to reduction of a specific surface area of the second surface, recombination on the second surface is reduced, and the passivation effect of the second surface is improved.

In some embodiments, the second surface includes first doped regions 108 and second doped regions 109 spaced apart and alternatingly arranged, the first doped regions 108 are doped with doping ions of a conductivity type that is the same as that of the substrate 100, and the second doped regions 109 are doped with doping ions of a conductivity type different from that of the substrate 100. For example, the substrate is an N-type substrate, the first doped regions 108 are N-type doped regions, the second doped regions 109 are P-type doped regions, PN junctions are formed between the second doped regions 109 and the substrate 100, and carriers are effectively shunted.

In some embodiments, a doping concentration of the doping ions in a first doping region 108 is greater than a doping concentration of the doping ions in the substrate 100, a high-low junction is formed between the first doping region 108 and the substrate 100, and the capability for shunting carriers is enhanced.

A gap or an isolation structure is provided between a first doped region 108 and a second doped region 109, so as to achieve automatic isolation between regions of different conductive types, which avoids heavily doped P-type regions and N-type regions of the rear surface of the IBC cell from forming tunnel junctions to cause electric leakage to affect the cell efficiency.

In some embodiments, the passivation layer 123 is formed on the first doped regions 108 and the second doped regions 109.

The passivation layer 123 may include a single-layer film layer structure or a laminated film layer structure, and a material of the passivation layer 123 includes at least one of silicon oxide, silicon nitride, silicon oxynitride, silicon oxide carbonitride, titanium oxide, hafnium oxide, aluminum oxide, etc.

In some embodiments, the first fingers 121 penetrate the passivation layer 123 to be electrically connected to the first doped regions 108, and the second fingers 122 penetrate the passivation layer 123 to be electrically connected to the second doped regions 109.

The first fingers 121 and the second fingers 122 are used for collecting and summarizing the current of the solar cell. Any of the first fingers 121 and the second fingers 122 are sintered from a burn-through paste. A method for forming the first fingers 121 or the second fingers 122 includes printing a metal paste on a portion of a surface of the passivation layer 123 or an antireflection layer by using a screen-printing process. The metal paste may include at least one of silver, aluminum, copper, tin, gold, lead, or nickel. In some embodiments, the metal paste has a material of a highly corrosive component such as glass powder, so that the corrosive component corrodes the passivation layer 123 or the antireflection layer in the sintering process, thereby the metal paste permeates in the passivation layer 123 or the antireflection layer so as to be in electrical contact with the first doped regions 108 or the second doped regions 109.

In some embodiments, the solar cell includes a front passivation layer 124 formed over the first surface (i.e., the front surface). The front passivation layer 124 may be a single-layer structure or a laminated structure, and a material of the front-surface passivation layer 124 includes at least one of silicon oxide, silicon nitride, silicon oxynitride, silicon oxide carbonitride, titanium oxide, hafnium oxide, aluminum oxide, etc.

In some embodiments, the solar cell further includes antireflection layers each formed on a side of the passivation layer away from the substrate and a side of the front passivation layer away from the substrate, respectively. Each of the first fingers penetrates the antireflection layer and the passivation layer to be in electrical contact with a respective first doped region, each of the second fingers penetrates the antireflection layer and the passivation layer to be in electrical contact with a respective second doped region. A refractive index of the antireflection layer is high, so that reflection damage of the rear surface of the cell is reduced, and the material of the antireflection layer may be one or both of silicon nitride or silicon oxynitride.

In some embodiments, the fingers extend in the second direction X, the first direction Y and the second direction X may be perpendicular to each other, or an included angle between the first direction Y and the second direction X may be less than 90 degrees, for example, 60 degrees, 45 degrees, 30 degrees, etc., as long as the first direction Y and the second direction X are not the same direction. For ease of description and understanding, as an example, the first direction Y and the second direction X are perpendicular to each other for description. In a specific application, the included angle between the first direction Y and the second direction X may be adjusted according to actual needs and application scenarios, which is not limited in the embodiments of the present disclosure.

In some embodiments, the substrate 100 has a first boundary 101, a second boundary 102, a third boundary 103, and a fourth boundary 104 arranged adjacent to each other. The first boundary 101 is opposite to the third boundary 103 in the first direction Y, and the second boundary 102 is opposite to the fourth boundary 104 in the second direction X.

In some embodiments, a junction of the first boundary 101 and the second boundary 102, a junction of the second boundary 102 and the third boundary 103, a junction of the third boundary 103 and the fourth boundary 104, and a junction of the fourth boundary 104 and the first boundary 101 have chamfers. The reason for formation of the chamfers 105 is that a monocrystal silicon rod can only be made into a round due to extraction limitation of the monocrystal silicon process for preparing the substrate in conventional solar cells, the silicon rod is sliced after coming out, that is, the cross-section of the silicon rod is cut into the appearance of a monocrystal silicon wafer (after calculating the area, an area of illumination is maximized in a unit, the material of the silicon rod is saved to a greatest extent, and it is also convenient for the production of cells and modules), and the chamfers are often set at various junction of boundaries of the substrate to reduce external stress of the silicon wafer and avoid micro-damage at the corners of the silicon wafer.

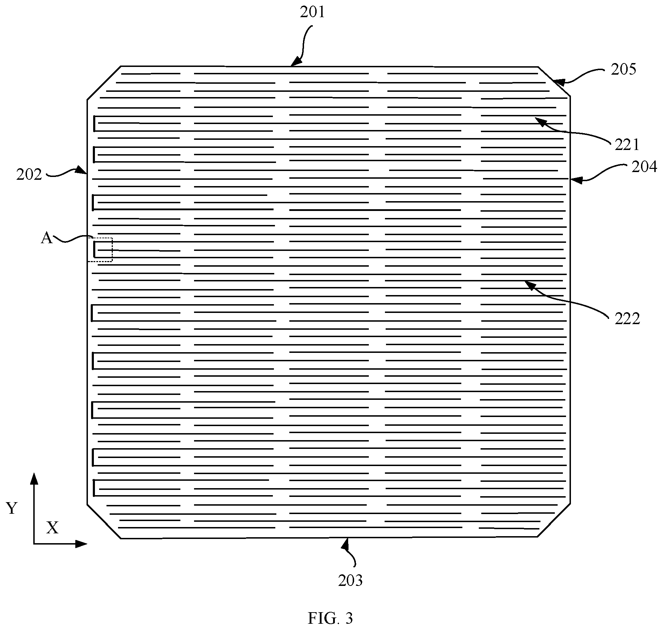

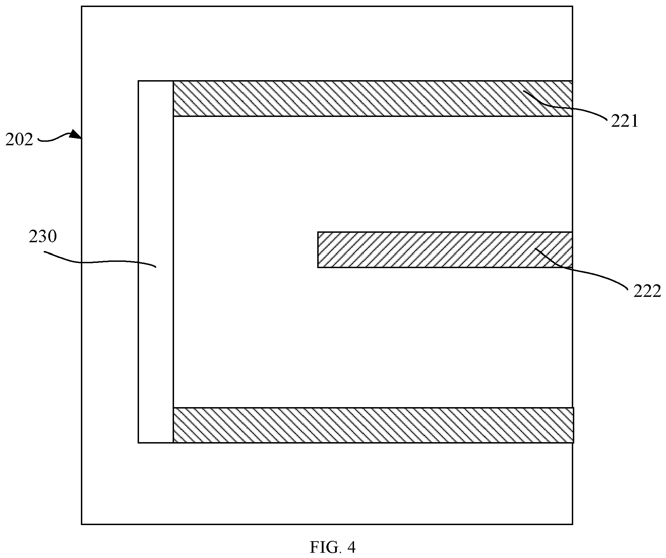

FIG. 3 is a schematic structural diagram of a second solar cell according to an embodiment of the present disclosure, and FIG. 4 is a schematic structural diagram of a connection electrode in the second solar cell according to an embodiment of the present disclosure. The second solar cell also has a cross-sectional structure as shown in FIG. 2, and a corresponding drawing may refer to FIG. 2.

Referring to FIG. 3 and FIG. 4, the solar cell includes a substrate, a passivation layer formed over a surface of the substrate, fingers, and connection electrodes 230. The fingers including rows of first fingers 221 and rows of second fingers 222 alternatingly arranged along a first direction Y, each finger of the fingers extending in a second direction X, each row of first fingers 221 including a corresponding set of first fingers 221 arranged at intervals in the second direction and each row of second fingers 222 including a corresponding set of second fingers 222 arranged at intervals in the second direction X. Each row of first fingers 221 is between two adjacent rows of second fingers 222. The fingers penetrate the passivation layer to be electrically connected to the substrate. Each of the connection electrodes 230 is in electrical contact with end portions of at least two adjacent first fingers 221 on one side of the rows of first fingers 221.

In some embodiments, the connection electrodes 230 are provided for improving a collection rate for the current generated by portions of the electrodes at the edge and a portion of the substrate at the edge. Each connection electrode 230 is in electrical contact with end portions of at least two adjacent first fingers 221 on the same side, so that the current generated by a finger at the second boundary 202 or the fourth boundary 204 of the substrate in the case where this finger provides a gap for a busbar with a different polarity from this finger to pass can be collected by another finger with the same polarity as this finger, thereby improving the collection efficiency and photoelectric conversion efficiency of the solar cell.

In some embodiments, the connection electrode 230 is a whole electrode connecting the adjacent first fingers 221, and an extension direction of the connection electrode 230 is perpendicular to an extension direction of the first finger 221, so that a printing screen of existing fingers can be partially modified or the connection electrodes 230 can be printed again to reduce the improvement on the current process, which improves the compatibility and applicability of the device.

In some embodiments, the extension direction of the connection electrode 230 is perpendicular to the extension direction of the first finger 221, and the extension direction of the connection electrode 230 is the first direction Y. The extension direction of the connection electrode 230 is parallel to an extension direction of the second boundary 202, which occupies a small proportion of a region of the substrate at the edge, so that the electrodes can be provided at a small distance from the second boundary 202, i.e., longer first fingers 221 can be formed and larger regions can be used for forming the busbars, thereby reducing the process difficulty.

In some embodiments, the material of the connection electrodes 230 is the same as the material of the fingers. The paste of the connection electrodes 230 is the same as the paste of the fingers, i.e., the connection electrodes 230 are formed by the burn-through paste, and the connection electrodes 230 also penetrate the passivation layer to be electrically connected to corresponding first doped regions. In this way, the connection electrodes 230 may not only collect the current of the first fingers 221, but also collect the current on a portion of the surface of the substrate adjacent to the second boundary 202 or the fourth boundary 204 by itself, thereby increasing collection paths and improving the current collection efficiency.

In some embodiments, the paste of the connection electrodes 230 is the same as the paste of the busbars, that is, the connection electrodes 230 are formed by non-burn-through paste, and the connection electrodes 230 are formed on the surface of the passivation layer, so that the first doped regions and the second doped regions on the surface of the substrate below the connection electrodes 230 may not need to be typeset to prevent short circuit caused by electrical contact between the connection electrodes 230 and the second doped regions of another polarity. In addition, the connection electrodes 230 may not damage the passivation layer, so that the integrity of the film layer of the passivation layer is ensured, which improves the passivation effect of the passivation layer on the substrate and is conducive to reducing the optical loss of the solar cell, thereby improving the photoelectric conversion efficiency of the solar cell. Furthermore, since the non-burn-through paste has no excessive glass powder to damage the PN junction, the metal recombination is effectively reduced, the open-circuit voltage of the solar cell is improved, and the conversion efficiency of the solar cell is improved.

The conventional paste includes a mixture of metal powder, glass powder, and an organic carrier. The non-burn-through paste refers to the paste containing lower glass powder content than that the conventional paste, having a weak burn-through capability in the sintering process, and not required or able to burn the paste of the passivation layer. The burn-through paste refers to the paste having a strong burn-through capability and able to burn through the passivation layer during the sintering process.

In some embodiments, a width of the connection electrode 230 in the second direction X is less than 30 µm. For example, the width of the connection electrode 230 is less than 28 µm, 26 µm, 23 µm, 20 µm, 18.3 µm, 15 µm, 12 µm, or 10 µm. When the width of the connection electrode 230 is within any of the above ranges, the connection electrode 230 has sufficient width to collect carriers of the substrate, and a cross-sectional area of the connection electrode 230 itself is large, thereby providing lower electrical loss. The connection electrode 230 also occupies a small area, so that it occupies a small area of the region at the boundary, which makes the second fingers 222 able to collect the current at the edge farther, thereby reducing increasing an area for collecting the current by the second fingers 222.

In some embodiments, the chamfers 205, the first boundary 201, the second boundary 202, the third boundary 203, the fourth boundary 204, the first fingers 221, and the second fingers 222 may refer to the descriptions of the chamfers 105, the first boundary 101, the second boundary 102, the third boundary 103, the fourth boundary 104, the first fingers 121, and the second fingers 122 in the above embodiments, and details are not described herein again.

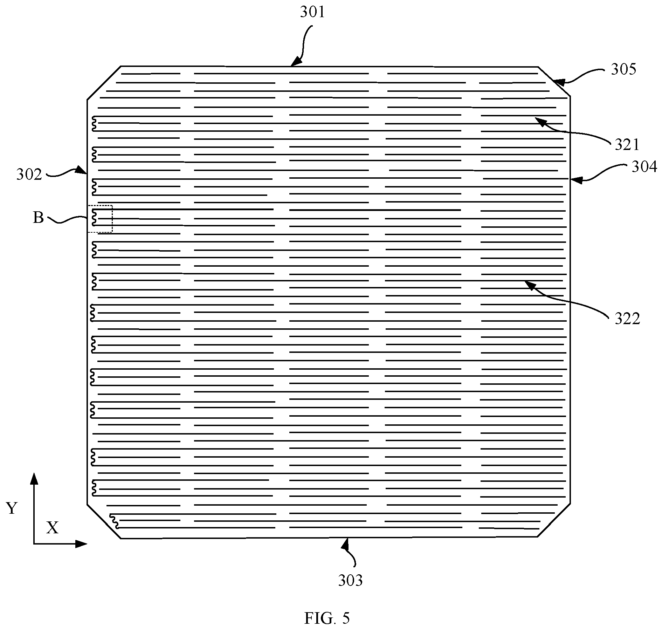

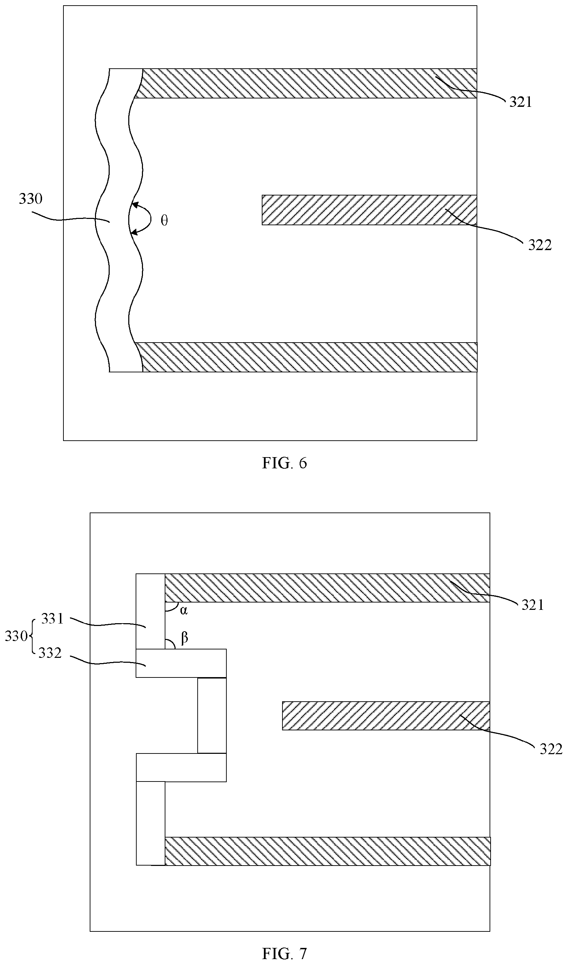

FIG. 5 is a schematic structural diagram of a third solar cell according to an embodiment of the present disclosure, FIG. 6 is a partial enlarged view of part B in FIG. 5, and FIG. 7 is a schematic structural diagram of a connection electrode in a third solar cell according to an embodiment of the present disclosure. The third solar cell also has a cross-sectional structure as shown in FIG. 2, and a corresponding drawing may refer to FIG. 2.

Referring to FIG. 5 and FIG. 6, some embodiments of the present disclosure provide a solar cell including a substrate, a passivation layer formed over a surface of the substrate, fingers, and connection electrodes 330. The fingers including rows of first fingers 321 and rows of second fingers 322 alternatingly arranged along a first direction Y, each finger of the fingers extending in a second direction X, each row of first fingers 321 including a corresponding set of first fingers 321 arranged at intervals in the second direction and each row of second fingers 322 including a corresponding set of second fingers 322 arranged at intervals in the second direction X. Each row of first fingers 321 is between two adjacent rows of second fingers 322. The fingers penetrate the passivation layer to be electrically connected to the substrate. Each connection electrode 330 is in electrical contact with end portions of at least two adjacent first fingers 321 on one side of the rows of first fingers 321, and each connection electrode 330 includes a curved wave-like structure, i.e., the connection electrode 330 has a curved wave-like shape.

In some embodiments, the connection electrode 330 has a curved wave-like shape. In the conventional process of preparing the connection electrode 330, the scraper advances in a direction parallel to an arrangement direction of the fingers and perpendicular to an extending direction of the fingers, and since the scraper needs to push the paste to fill holes of the screen plate in a direction perpendicular to or inclined to a surface of the substrate, so as to make the paste cover a surface of the passivation layer, a total area of holes on the same horizontal line is small, the paste can quickly fill the holes, so that the holes on different horizontal lines are communicate, thus the continuity of the connection electrode is good so as to avoid the gap, and the connection electrode 330 can fully play the function of collecting the current.

In addition, since the width of the connection electrode in the second direction is small, such as less than 30 µm, the length of the first finger in the second direction, the length of the second finger in the second direction and the length of the busbar in the second direction are increased, so that the current collection capacity of the cell is improved, and the problem that the paste cannot fill the holes due to the narrow connection electrode is avoided by making the connection electrode 330 in a curved wave-like shape. On the contrary, if the width of the connection electrode in the second direction is large, the paste is easy to fill the holes, and the connection electrode is designed to be in a curved wave-like shape, so that the current collection capability of the cell at the edge is improved.

In some examples, the holes on the same horizontal line refer to a horizontal line formed by connecting a plurality of holes in the first direction.

In some embodiments, the connection electrode 330 has a curved wave-like shape, compared with a straight linear shape, an contact area between an end portion of the connection electrode 330 and an end portion of the first finger 321 connected with the connection electrode 330 is large, so that the problem of the gap between the connection electrode 330 and the first finger 321 is avoided, and the contact area between the connection electrode 330 and the first finger 321 is large, thus the contact resistance between the connection electrode 330 and the first finger 321 is small, which improves the photoelectric conversion efficiency of the solar cell.

In some embodiments, a radian θ of any of arcs of the curved wave-like structure is in a range of 0.1 rad to π. The radian θ may be in a range of 0.1 rad to 0.3 rad, 0.3 rad to 0.6 rad, 0.6 rad to 1.1 rad, 1.1 rad to 1.5 rad, 1.5 rad to 1.9 rad, 1.9 rad to 2.2 rad, 2.2 rad to 2.9 rad, or 2.8 rad to π. In this way, the number of holes on the same horizontal line of the connection electrode 330 having the curved wave-like shape is appropriate, and the paste can fully fill each hole on the screen plate, thereby ensuring the continuity of the connection electrode 330.

In some embodiments, since the radian θ of any of arcs of the curved wave-like structure is in a range of 0.1 rad to π, any arc of the curved wave-like structure has a relatively small width in the second direction X, and larger regions may be provided to make the distance between the busbar and the second boundary 302 larger, thereby reducing the risk of damage to the second boundary 302, and the lengths of the first finger 321 and the second finger 322 in the second direction X are longer, so that the collection of carriers at the edge is more sufficient.

Referring to FIG. 7, each connection electrode 330 includes a sectional structure. The sectional structure includes at least a first connection section 331 and a second connection section 332 connected to each other. The first connection section 331 is in electrical contact with an end portion of the connection electrode 330, an included angle α between the first connection section 331 and the finger is not equal to 180°, and an included angle β between the first connection section 331 and the second connection section 332 is not equal to 180°.

In some embodiments, the included angle α between the first connection section 331 and the finger is equal to 20°, 30°, 49°, 68°, 90°, 108°, 120°, 150°, 175°, 197°, 210°, 260°, 300°, 310°, or 350°. The included angle β between the first connection section 331 and the second connection section 332 is equal to 18°, 32°, 47°, 60°, 90°, 107°, 120°, 149°, 168°, 220°, 260°, or 349°.

When the included angle α between the first connection section 331 and the finger is not equal to 180° and the included angle β between the first connection section 331 and the second connection section 332 is not equal to 180°, or, the included angle α and the included angle β are within any of the above ranges, for the connection electrode of the same horizontal line in the process of preparing the connection electrode including the first connection section 331 and the second connection section 332, less paste is used to fill the holes, so the paste can be continuously located on the surface of the passivation layer, and there is no gap between the first finger 321 and the first connection section 331.

In some embodiments, a connection electrode between two adjacent first fingers 321 includes a plurality of groups of first connection sections 331 and second connection sections 332 which are alternatingly arranged. The connection electrode is split into a plurality of first connection sections 331 and second connection sections 332 which are alternatingly arranged, so that the length of the connection electrode is increased, thereby increasing a region where the connection electrode collects carriers.

In some embodiments, the first connection sections 331 of different groups are arranged in a staggered manner along the second direction X, that is, an extension line in the first direction Y of a first connection section 331 in one group does not overlap with an extension line in the first direction Y of a first connection section in another group, so that the number of the first connection sections of the same horizontal line is small in the process of forming the connection electrode, and a total area of the paste required to fill the holes on the same horizontal line is small, so that the continuity of the connection electrodes is ensured.

In some embodiments, lengths of second connection sections 332 of different groups may be the same or different.

In some embodiments, the solder strip is in contact with the finger, so that busbars in a conventional solar cell are omitted, which reduces the preparation cost of the busbars and reduces the shielding of the busbars, thereby improving the photoelectric conversion efficiency of the solar cell.

Accordingly, embodiments of the present disclosure provide a solar cell including busbars in electrical contact with the solder strips, and the current on the fingers is collected by means of the busbars, which avoids the problem of the gaps or pseudo soldering between the solder strips and the fingers, thereby improving the current collection efficiency of the cell.

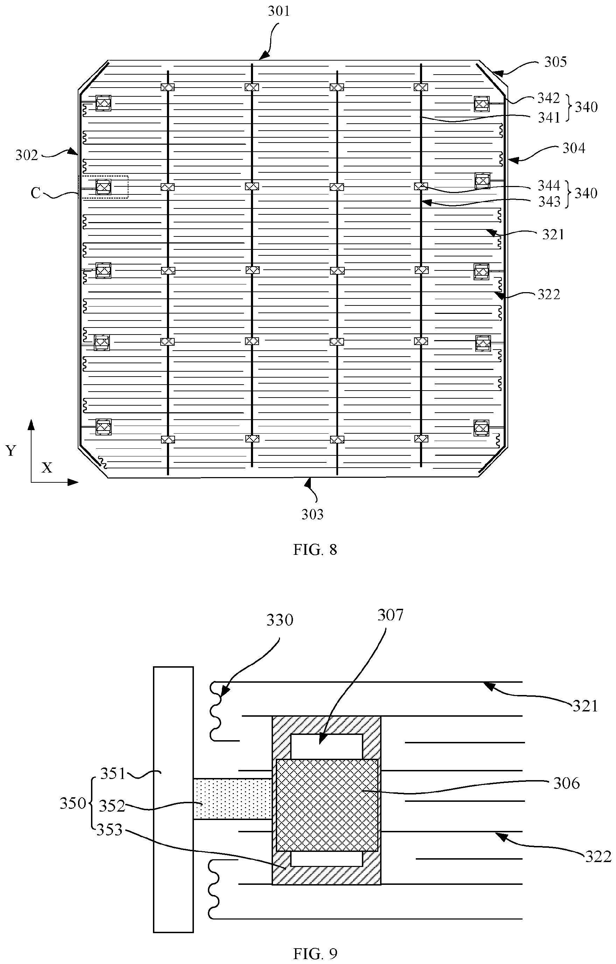

FIG. 8 is a schematic structural diagram of a fourth solar cell according to an embodiment of the present disclosure, and FIG. 9 is a partial enlarged view of part C in FIG. 8. The fourth solar cell also has a cross-sectional structure as shown in FIG. 2, and a corresponding drawing may refer to FIG. 2.

In some embodiments, referring to FIG. 8 and FIG. 9, the solar cell further includes busbars 340 including first busbars 341 and second busbars 342 which are alternatingly arranged in the second direction X. The first busbars 341 are electrically connected to the first fingers 321, and the second busbars 342 are electrically connected to the second fingers 322.

In some embodiments, the busbars 340 may be prepared from the non-burn-through paste. The busbars 340 are configured to collect the current collected by the fingers, and summarize and transmit the current to the solder strips.

In some embodiments, each busbar 340 includes a connection line 343 and a plurality of connection pads 344, the connection line 343 is electrically connected to the fingers, and the connection pads 344 are configured to be electrically connected to the solder strips. That is to say, the busbar herein is not a busbar in a conventional sense, but forms a connected bridge with each finger through the connection line, and is connected to the solder strips through the connection pads for collecting the current, so that a width of the connection line can be set to be thinner, which reduces an effective light-shielding area and resistance loss, thereby improving a total power of the module. The connection lines are set more densely to shorten a path of the current through the finger, thereby improving the photoelectric conversion efficiency of the solar cell. The thinner connection line and connection pad can also avoid the risk of hidden cracks and micro-cracks in the silicon wafer, so that the connection line is set at the edge of the solar cell with risk of hidden cracks and micro-cracks, thereby improving the current collection capability at the edge and improving the current collection or conduction path.

In some embodiments, the busbars adjacent to the second boundary 302 or the fourth boundary 304 are defined as edge busbars. If the number of busbars is an even number, i.e., edge busbars respectively adjacent to the second boundary 302 and the fourth boundary 304 have different polarities, one of the edge busbars is in electrical contact with the plurality of second fingers 322 arranged in the first direction, the other of the edge busbars is in electrical contact with the plurality of first fingers 321 arranged in the first direction, and the connection electrodes 330 are connected to the end portions of the second fingers 322 close to the fourth boundary 304. If the number of busbars is an odd number, i.e., edge busbars respectively adjacent to the second boundary 302 and the fourth boundary 304 have the same polarity, the two edge busbars are in electrical contact with the plurality of second fingers 322 arranged in the first direction, respectively. As an example, an edge busbar 350 is in electrical contact with the plurality of second fingers 322.

In some embodiments, referring to FIG. 9, the edge busbar 350 includes a first connection line 351 extending in the first direction, at least one electrical connection line 352, and a connection pattern 353. The at least one electrical connection line 352 is provided between the first connection line 351 and the connection pattern 353, and an extension direction of the electrical connection line 352 intersects with the first direction Y. The connection pattern 353 is provided on the second fingers 322 and is in electrical contact with the second fingers 322, and the first connection line 351 is provided on the side of the electrical connection line 352 adjacent to the second boundary 302. In this way, a soldering effect is ensured when the soldering is performed on the connection pattern 353, to avoid that a solder joint is too close to the edge of the rear surface, resulting in soldering cracks at the end of the module when the back contact solar cell is used as well as poor appearance due to a final soldering position offsetting from a cell region caused by solder strip offset during the soldering. The connection pattern 353 is connected with the first connection line 351 through the at least one electric connection line 352, so as to ensure that the module formed from soldered back contact solar cells can obtain edge photogenerated carriers collected on the second fingers 322 and the edge busbar 350, thereby ensuring the carrier utilization rate.

The boundaries extending in the second direction X of the connection pattern 353 being aligned with the second fingers 322 as shown in FIG. 9 is merely an example. In an actual solar cell, the connection pattern may be in contact with a side surface of the second finger, the connection pattern may be in contact with a portion of a top surface of the second finger, or the connection pattern may completely cover a portion of the top surface of the second finger and extend between adjacent second fingers (i.e., the connection pattern traverses a portion of the top surface of the second finger).

In some embodiments, the solar cell further includes solder joints 306, the solder joints 306 are provided on the passivation layer, and each solder joint 306 is electrically connected to the edge busbar 350. The solder joint 306 is located on the connection pattern 351. The solder joint 306 is configured to be electrically connected to a solder strip. In some embodiments, the solder joint 306 belongs to a portion of the edge busbar.

The solder joint being aligned with boundaries extending in the first direction Y of the connection pattern as shown in FIG. 9 is merely an example. In an actual solar cell, the solder joint may be in contact with an inner side surface of the connection pattern, the solder joint may be in contact with a portion of a top surface of the connection pattern, or the solder joint may completely cover a portion of the top surface of the connection pattern and extend to the electrical connection line, the second fingers, or a surface of the passivation layer (i.e., the solder joint traverses a portion of the top surface of the connection pattern).

In some embodiments, a first distance between the solder joint 306 and the second boundary 302 is greater than a second distance between the edge busbar 350 and the second boundary 302, where the second distance may be a distance between the first connection line and the second boundary. A third distance between the connection electrode 330 and the second boundary 302 is greater than the second distance between the edge busbar 350 and the second boundary 302, so that the edge busbar 350 may collect the current at the edge, and the connection electrode 330 is relatively far from the second boundary 302, thereby avoiding damage to the edge by the process.

In some embodiments, the third distance between the connection electrode 330 and the second boundary 302 is greater than the second distance. That is, the connection electrode 330 is located between the connection pattern 353 and the first connection line 351, so that the length of the first finger 321 in the second direction X may be increased, and the first fingers 321 may collect the current close to the second boundary 302, thereby improving the collection capability of the current at the edge.

The connection electrode 330 is located between the connection pattern 353 and the first connection line 351, and the connection electrode 330 may collect the current generated by the first fingers 321 close to the second boundary 302 which have gaps for formation of the connection pattern 353, thereby improving the collection capability of the current at the edge.

The first distance may be defined as a vertical distance between a midpoint of the solder joint and the second boundary, or a vertical distance between an outer side of the solder joint close to the second boundary and the second boundary. Similarly, the second distance is defined as a vertical distance between an axis of the first connection line and the second boundary, or a vertical distance between an outer side of the first connection line close to the second boundary and the second boundary. The third distance is defined as a vertical distance between the axis of the connection electrode 330 and the second boundary 302 or a vertical distance between an outer side of the connection electrode 330 close to the second boundary and the second boundary 302.

In some embodiments, the connection pattern 353 has a hollow region 307, and the solder joint 306 partially overlaps with the hollow region 307. Since the connection pattern adopts a hollow design, the paste consumption of the edge busbar is reduced, so that the paste is saved and the production and preparation cost of the cell are reduced. In addition, for a solder joint region required by the solder strip, a height of the hollowed region of the connection pattern is the lowest, and a height difference is formed between the edge busbar and the hollow region as well as between the solder joint and the hollow region, which is conducive to the contact between the solder strip and the solder joint as well as the edge busbar and the soldering of the module, thereby improving the production yield of the module.

In the embodiments of the present disclosure, the connection electrodes 330 are provided, each connection electrode 330 is in electrical contact with end portions of at least two adjacent first fingers 321 on a same side, and a hollow square-shaped electrode is formed by the connection electrode 330 and the fingers, so that an area of a portion of the electrode at the edge is increased, and the current collection capability is improved.

In addition, the connection electrode 330 has a curved wave-like shape. In the conventional process of preparing the connection electrode 330, the scraper advances in a direction parallel to an arrangement direction of the fingers and perpendicular to an extending direction of the fingers, and since the scraper needs to push the paste to fill holes of the screen plate in a direction perpendicular to or inclined to a surface of the substrate, so as to make the paste cover a surface of the passivation layer, a total area of holes on the same horizontal line is small, the paste can quickly fill the holes, so that the holes on different horizontal lines are communicate, thus the continuity of the connection electrode is good so as to avoid the gap, and the connection electrode 330 can fully play the function of collecting the current. The connection electrode 330 has a curved wave-like shape, compared with a straight linear shape, an contact area between an end portion of the connection electrode 330 and an end portion of the first finger 321 connected with the connection electrode 330 is large, so that the problem of the gap between the connection electrode 330 and the first finger 321 is avoided, and the contact area between the connection electrode 330 and the first finger 321 is large, thus the contact resistance between the connection electrode 330 and the first finger 321 is small, which improves the photoelectric conversion efficiency of the solar cell.

The connection electrode 330 includes at least the first connection section 331 and the second connection section 332 connected to each other. The first connection section 331 is in electrical contact with the end portion of the connection electrode 330, the included angle α between the first connection section 331 and the finger is not equal to 180°, and the included angle β between the first connection section 331 and the second connection section 332 is not equal to 180°. For the connection electrode of the same horizontal line in the process of preparing the connection electrode 330 including the first connection section and the second connection section, less paste is used to fill the holes, so the paste can be continuously located on the surface of the passivation layer, and there is no gap between the first finger 321 and the first connection section 331.

In some embodiments, the chamfers 305, the first boundary 301, the second boundary 302, the third boundary 303, the fourth boundary 304, the first fingers 321, and the second fingers 322 may refer to the descriptions of the chamfers 105, the first boundary 101, the second boundary 102, the third boundary 103, the fourth boundary 104, the first fingers 121, and the second fingers 122 in the above embodiments.

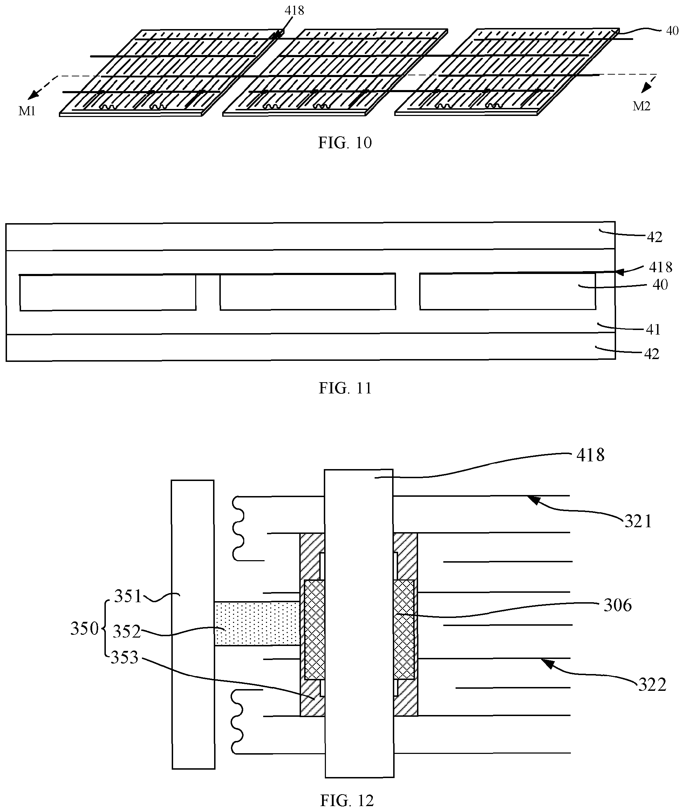

FIG. 10 is a schematic structural diagram of a photovoltaic module according to an embodiment of the present disclosure, FIG. 11 is a schematic cross-sectional view of FIG. 10 along section line M1-M2, and FIG. 12 is a partial schematic structural diagram of a cell and a solder strip in a photovoltaic module according to an embodiment of the present disclosure.

According to some embodiments of the present disclosure, with reference to FIG. 10 to FIG. 12, some embodiments of the present disclosure further provide a photovoltaic module, including: at least one cell strings each formed by connecting a plurality of solar cells 40 of any one of the above embodiments, at least one solder strip 418 each configured to electrically connect the plurality of solar cells 40 to form each of at least one cell string, at least one encapsulating adhesive film 41 each configured to cover a surface of a respective cell string, and a cover plate 42 each configured to cover a surface of a respective encapsulating adhesive film 41 facing away from the plurality of cell strings.

In some embodiments, a gap is not provided between the cells, that is, the cells overlap with each other. The solar cell is referred to as a cell for short.

In some embodiments, referring to FIG. 12, the solder strip 418 is soldered to the solder joint 306 of the solar cell 40. An orthographic projection of the solder strip 418 on the substrate does not overlap with an orthographic projection of the edge busbar 350 on the substrate. In this way, for the busbar at the edge, the solder strip can collect the current through the solder joint 306, which will not cause damage to the edge of the cell, so that the yield of the photovoltaic module is improved.

In some embodiments, the at least one encapsulation adhesive film 41 includes a first encapsulation layer and a second encapsulation layer, the first encapsulation layer covers one of the front surface or the rear surface of the solar cell 40, and the second encapsulation layer covers the other of the front surface or the rear surface of the solar cell 40. Specifically, at least one of the first encapsulation layer or the second encapsulation layer may be an organic encapsulation adhesive film such as polyvinyl butyral (PVB) adhesive film, ethylene-vinyl acetate copolymer (EVA) adhesive film, polyethylene octene co-elastomer (POE) adhesive film or polyethylene terephthalate (PET) adhesive film.

It should be understood that the first encapsulation layer and the second encapsulation layer have a boundary before lamination processing, and the photovoltaic module formed after the lamination processing does not have the so-called first encapsulation layer and second encapsulation layer, that is, the first encapsulation layer and the second encapsulation layer have formed an integral encapsulation layer 41.

In some embodiments, the at least one cover plate 42 may be a cover plate having a light-transmitting function, such as a glass cover plate and a plastic cover plate. Specifically, a surface of the cover plate 42 facing the encapsulation layer 41 may be a concave-convex surface, thereby increasing the utilization rate of incident light. The at least one cover plate 42 includes a first cover plate and a second cover plate, the first cover plate faces the first encapsulation layer, and the second cover plate faces the second encapsulation layer.

Although some embodiments of the present disclosure are provided in the above, but these embodiments are not intended to limit the claims, any person skilled in the art may make certain possible changes and modifications without departing from the conception of the present disclosure, and therefore the protection scope of the present disclosure shall be subject to the scope defined in the claims of the present disclosure. In addition, the embodiments in the specification and the accompanying drawings of the present disclosure are only illustrative examples, and are not intended to cover the entire protection scope of the claims in the present disclosure.

Any person of ordinary skill in the art can understand that the above embodiments are specific embodiments for realizing the present disclosure, and that in practical application, various changes may be made thereto in form and details without departing from the scope of the present disclosure. Any person skilled in the art may make various changes and modifications without departing from the scope of the present disclosure, and therefore the protection scope of the present disclosure shall be subject to the scope defined in the claims.

## Claims

1. A solar cell, comprising:
a substrate;
a passivation layer formed over a surface of the substrate;
fingers arranged in a first direction and extending in a second direction, wherein the fingers penetrate the passivation layer to be electrically connected to the substrate and include first fingers and second fingers which are alternatingly arranged;
connection electrodes, wherein each of the connection electrodes is in electrical contact with end portions of at least two adjacent first fingers on a same side and includes one of the following:
at least a first connection section and a second connection section connected to each other, wherein the first connection section is connected to an end portion of a respective finger of the at least two adjacent first fingers, the first connection section and the respective finger has an included angle that is not equal to 180°, and the first connection section and the second connection section has an included angle that is not equal to 180°; and
a curved wave-like structure.

2. The solar cell according to claim 1, wherein the substrate has a first boundary, a second boundary, a third boundary, and a fourth boundary adjacent to each other, wherein the first boundary is opposite to the third boundary in the first direction, and the second boundary is opposite to the fourth boundary in the second direction.

3. The solar cell according to claim 2, further comprising: edge busbars adjacent to the second boundary, wherein the edge busbars are in electrical contact with the second fingers arranged in the first direction.

4. The solar cell according to claim 3, further comprising: solder joints provided on the passivation layer, wherein each of the solder joints is electrically connected to a respective one of the edge busbars, and wherein each of the solder joints and the second boundary have a first distance that is greater than a second distance between any of the edge busbars and the second boundary.

5. The solar cell according to claim 4, wherein each of the connection electrodes and the second boundary have a third distance greater than the second distance.

6. The solar cell according to claim 4, wherein each of the edge busbars includes a first connection line extending in the first direction, at least one electrical connection line, and a connection pattern; wherein the at least one electrical connection line is provided between the first connection line and the connection pattern and extends in a direction intersecting with the first direction, the connection pattern is provided on and in electrical contact with some of the second fingers, and the first connection line is provided on a side of the at least one electrical connection line close to the second boundary; and wherein a respective one of the solder joints is provided on the connection pattern.

7. The solar cell according to claim 6, wherein the connection pattern has a hollow region, and the respective one of the solder joints partially overlaps with the hollow region.

8. The solar cell according to claim 1, wherein each of the connection electrodes includes a plurality of groups of first connection sections and second connection sections which are alternatingly arranged.

9. The solar cell according to claim 1, wherein the connection electrodes have materials the same as materials of the fingers.

10. The solar cell according to claim 1, wherein the curved wave-like structure includes a plurality of arcs each having a radian in a range of 0.1 rad to π.

11. The solar cell according to claim 1, wherein each of the connection electrodes has a width less than 30 µm.

12. The solar cell according to claim 1, wherein the solar cell includes an interdigitated back contact, IBC, cell.

13. The solar cell according to claim 1, wherein each of the first fingers has a first polarity and each of the second fingers has a second polarity.

14. A photovoltaic module, comprising:
at least one cell strings each formed by connecting a plurality of solar cells according to any one of claims 1 to 13;
at least one solder strip each configured to electrically connect the plurality of solar cells to form each of at least one cell string;
at least one encapsulating adhesive film each configured to cover a surface of a respective cell string; and
at least one cover plate each configured to cover a surface of a respective encapsulating adhesive film facing away from the plurality of cell strings.

15. The photovoltaic module according to claim 14, wherein the at least one solder strip each is soldered to solder joints of each of the plurality of solar cells, and each of the at least one solder strip has an orthographic projection on the substrate that does not overlap with an orthographic projection of a respective one of the edge busbars on the substrate.
